**Europäisches Patentamt**

**European Patent Office**

**Office européen des brevets**

(19)

(11) Veröffentlichungsnummer : **0 106 272 B1**

(12) **EUROPÄISCHE PATENTSCHRIFT**

(45) Veröffentlichungstag der Patentschrift :
03.01.90

(21) Anmeldenummer : 83109957.7

(22) Anmeldetag : 05.10.83

(51) Int. Cl.⁵ : **B 60 R 16/02**

(54) Prüfeinrichtung für Stromkreise eines Kraftfahrzeugs.

(30) Priorität : 07.10.82 DE 3237164

(43) Veröffentlichungstag der Anmeldung :
25.04.84 Patentblatt 84/17

(45) Bekanntmachung des Hinweises auf die Patenterteilung : 03.01.90 Patentblatt 90/01

(84) Benannte Vertragsstaaten :
DE FR GB IT SE

(56) Entgegenhaltungen :
EP--A-- 0 039 122
DE--A-- 2 433 025
DE--A-- 3 024 266

(73) Patentinhaber : Bayerische Motoren Werke Aktiengesellschaft
Patentabteilung AJ-3 Postfach 40 02 40 Petuelring 130
D-8000 München 40 (DE)

(72) Erfinder : Deicke, Axel, Dipl.-Ing.
Hamsterweg 9
D-8011 Baldham (DE)
Erfinder : Tigges, Michael
Lantbertstrasse 3
D-8050 Freising (DE)

(74) Vertreter : Bullwein, Fritz
Bayerische Motoren Werke Aktiengesellschaft Postfach 40 02 40 Petuelring 130 AJ-33
D-8000 München 40 (DE)

**Beschreibung**

Die Erfindung bezieht sich auf eine Prüfeinrichtung für Stromkreise eines Kraftfahrzeugs, bei denen Eingangssignale in einer gemeinsamen zentralen Steuereinheit in Ausgangssignale zum Schalten verschiedener Verbraucher umgesetzt und die Verbraucher unabhängig von den Eingangssignalen geschaltet werden.

Es ist eine derartige Prüfeinrichtung bekannt, bei der ein Ersatzsignalgenerator der Steuereinheit entsprechende Eingangssignale liefert. Die von der Steuereinheit gelieferten Ausgangssignale können wahlweise den tatsächlichen Verbrauchern oder Ersatzlasten zugeführt werden. Die Prüfung wird mit Hilfe eines Zählers vorgenommen, der die Ausgangssignale der Steuereinheit bestimmt (vgl. DE-OS 30 24 266). Diese Prüfrichtung ist schaltungstechnisch aufwendig und fordert zusätzliche Bauteile, z. B. in Form der Ersatzlasten.

Ferner ist aus ·der EP-A-0 039 122 eine Prüfrichtung für elektrische Verbraucher eines Kfz's bekannt, die sich über separate Leitungen zu Prüfzwecken individuell direkt einschaltet. Dabei ist ein Eingriff in den eigentlichen Stromkreis des Verbrauchers nicht vorgesehen.

Der Erfindung liegt die Aufgabe zugrunde, eine Prüfeinrichtng der eingangs genannten Art zu schaffen, die auf schaltungstechnisch einfache Weise und mit nur geringem Mehraufwand eine weitgehend ausreichende Prüfung der Verbraucher-Stromkreise ermöglicht.

Die Erfindung löst diese Aufgabe durch einen Generator (20), der für Verbraucher, die durch Lastschalter (10' bis 13') geschaltet sind, den Ausgangssignalen der Steuereinheit (1) zumindest ähnliche Signale erzeugt und diese zyklisch zu den Verbrauchern liefert.

Grundlegend für die Erfindung sind im wesentlichen zwei Überlegungen. Zum einen treten Fehler der Stromkreise im wesentlichen bei der Erzeugung bzw. Verarbeitung der Ausgangssignale auf. Zum anderen läßt sich vielfach die Arbeitsweise der Verbraucher ohne zusätzliche Hilfsmittel feststellen. Hierbei sind die unter der Bezeichnung Karosserieelektrik bekannten Verbraucher wie Beleuchtungs-, Signal- und Reinigungseinrichtungen zu nennen. Ferner zählen hierzu der Brennkraftmaschine zugeordnete elektrische Verbraucher wie Anlassermotor und Kraftstofförderpumpen. Bei der Erfindung wird der relativ störunempfindliche Teil der Stromkreise, der im wesentlichen die Erzeugung und Aufnahme der Eingangssignale umfaßt, abgetrennt und lediglich der störungsempfindliche Teil geprüft. Die Prüfung erfolgt lediglich anhand der Arbeitsweise der Verbraucher, die bei fehlerfreiem Betrieb nacheinander kurzzeitig eingeschaltet werden. Da der Prüfablauf bei gleichen Fahrzeugen gleich ist, wird jede Abweichung hiervon aufgrund eines fehlerhaft oder überhaupt nicht arbeitenden Verbrauchers ohne Mühe erkannt und eine entsprechende Servicemaßnahme eingeleitet.

Eine weitere schaltungstechnische Vereinfachung besteht darin, daß der Generator in der Steuereinheit integriert ist. Diese Maßnahme bietet gerade bei Verwendung eines Mikroprozessors in der Steuereinheit den zusätzlichen Vorteil, daß sie kostengünstig durch eine relativ geringfügige zusätzliche Programmierung durchgeführt werden kann.

Ebenfalls der Verringerung des schaltungstechnischen Aufwands dient eine Maßnahme, die die Aktivierung des Generators zum Inhalt hat. Diese Maßnahme läßt sich besonders einfach dadurch erreichen, daß der Generator mittels eines kurzen Prüfbefehls aktivierbar ist. Die zyklische Ansteuerung der Verbraucher erfolgt dann selbsttätig und ohne weiteren Eingriff.

Durch die Erfindung läßt sich feststellen, ob ein vorhandener Fehler tatsächlich in dem Teil der Stromkreise aufgetreten ist, die der Erzeugung bzw. Verarbeitung der Ausgangssignale dienen. Ergibt sich bei dieser Prüfung jedoch, daß ein Fehler nicht aus diesem Teil der Stromkreise stammt, so kann durch eine zusätzliche Maßnahme auch der Teil der Stromkreise geprüft werden, der sich mit den Eingangssignalen befaßt. Sind nämlich die Eingangssignal auf einer Anzeigeeinrichtung darstellbar, so kann ein fehlerhaftes bzw. nicht vorhandenes Eingangssignal ohne weiteres erkannt bzw. von mehreren möglichen fehlerhaften Eingangssignalen das tatsächlich fehlerhafte Eingangssignal identifiziert werden.

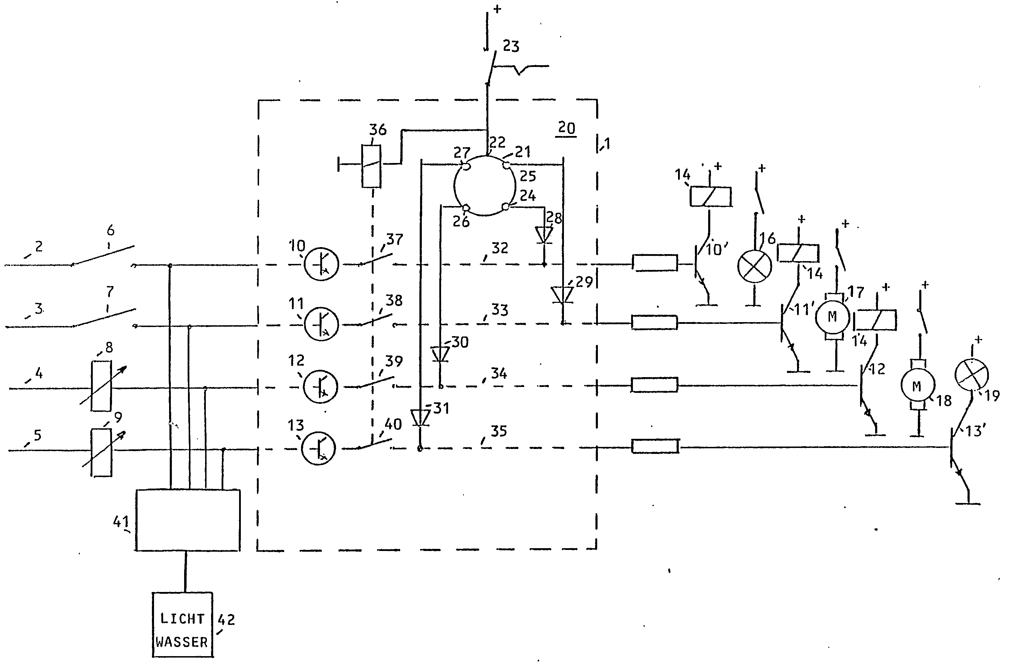

In der Figur ist ein schaltungsmäßiger Aufbau einer erfindungsgemäßen Prüfeinrichtung als Ausführungsbeispiel dargestellt.

Eine dargestellte Prüfeinrichtung ist Stromkreisen eines Kraftfahrzeugs zugeordnet. Diesen gemeinsam ist eine Steuereinheit 1, in der Eingangssignale in Ausgangssignale umgesetzt werden. Die Eingangssignale gelangen auf parallelen Eingangsleitungen, von denen der Einfachheit halber lediglich die Eingangsleitungen 2 bis 5 dargestellt sind, zur Steuereinheit 1. Sie stammen von Schaltern 6 und 7 oder Sensoren 8 und 9 in Form veränderlicher Widerstände, wobei in letzterem Fall beispielsweise innerhalb der Steuereinheit 1 Komperatoren oder dgl. vorgesehen sein können, die bei einem vorgebenen Wert des Widerstands ein Schaltsignal auslösen.

In der Steuereinheit 1 werden die in erster Linie als Schaltsignale vorliegenden Eingangssignale über geeignete Elemente, beispielsweise in Form von angedeuteten Schalttransistoren 10 bis 13 in ebenfalls als Schaltsignale gegebene Ausgangssignale umgesetzt.

Die Ausgangssignale können beispielsweise Lastschalter in Form von Leistungstransistoren zugeführt werden, die elektrische Verbraucher schalten bzw. steuern. Die Verbraucher können Relais 14 zum Steuern von Beleuchtungseinrichtungen wie Scheinwerfer-Glühlampen 16 oder zum Steuern von Antriebs- bzw. Stellmotoren 17 und 18, beispielsweise für eine Scheiben-Reinigungs- bzw. Heizanlage, oder aber auch Kontrollampen 19 für kritische Betriebsfunktionen sein.

Zur Kontrolle des Teils der elektrischen Stromkreise, der von den Schaltransistoren 10 bis 13 bis zu den Lastschaltern 10' bis 13' reicht, ist in der Steuereinheit 1 ein Generator 20 integriert, der dieselben Ausgangssignale wie die Schalttransistoren 10 bis 13 erzeugen kann. Der Generator 20 besteht im wesentlichen aus einem Drehschalter 21, dessen Eingang 22 mit Hilfe eines Schalters 23 als Befehlsgeber für eine bestimmte Zeit bleibend auf (+)-Potential gelegt werden kann und dessen Ausgänge 24 bis 27 über Dioden 28 bis 31 an den Verbindungsleitungen 32 bis 35 zwischen den Schalttransistoren 10 bis 13 und den Lastschaltern 10' bis 13' angeschlossen sind. Der Drehschalter 21 ist dabei so ausgelegt, daß er zyklisch seine vier Stellungen einnimmt und in diesen Stellungen jeweils kurzzeitig verbleibt, sobald der Schalter 23 geschlossen ist. Mit Hilfe des Schalters 23 ist ferner ein Relais 36 schaltbar, das jeweils einen Öffnerkontakt 37 bis 40 in jeder der genannten Verbindungsleitungen 32-35 betätigt.

Mit Hilfe des dargestellten Schaltungsaufbaus ist es möglich, die dargestellten Lasten 16 bis 19 und ihre zugeordneten Lastschalter zu überprüfen. Hierzu wird der Schalter 23 geschlossen. Der Drehschalter 21 versorgt zyklisch die Lastschalter 10' bis 13' mit (+)-Potential. Die Funktionsfähigkeit der Lasten 16 bis 19 und ihrer zugeordneten Lastschalter 10'-13' läßt sich damit unabhängig von den Eingangssignalen der Steuereinheit 1 überprüfen. Diese Überprüfung erfolgt optisch und/oder akustisch und in der Regel ohne Hilfsmittel. Sofern die Lasten und ihre Lastschalter in Ordnung sind, werden die Lasten in einer vorgegebenen Reihenfolge und kurzzeitig eingeschaltet. jeder Ausfall einer Last bzw. des Lastschalters ist ohne weiteres anhand einer Störung dieses vorgegebenen, an sich bei sämtlichen Fahrzeugen beispielsweise einer Modellreihe gleichen Schaltzyklus sofort erkennbar.

Die Prüfung mit Hilfe des Drehschalters 21 und der bei dieser Prüfung durch das Relais 36 abgetrennten Verbindung zu den Eingangssignalen der Steuereinheit 1 ist auf den störanfälligeren Teil der Stromkreise beschränkt. Sollte sich bei dieser Prüfung jedoch herausstellen, daß der geprüfte Teil eines als fehlerhaft erkannten Stromkreises in Ordnung ist, ergibt sich damit zwangsläufig, daß der Fehler nur in den Teilen der Stromkreise zu suchen ist, die von den eingangsseitigen Gebern bzw. Schaltern 6 bis 9 der Steuereinheit 1 bis hin zu den Öffnerkontakten 37 bis 40 reichen. Die Fehlersuche ist dann lediglich auf diesen Teil der Stromkreise zu beschränken.

Um gerade in einem derartigen Fall die Fehlersuche zu erleichtern, können die Eingangsleitungen 2 bis 5 über einen Codierer 41 auf eine Anzeige 42 geschaltet sein. Damit kann während des mit Hilfe des Drehschalters 21 durchgeführten Testzyklus eine separate Prüfung der Schalter 6 und 7 bzw. Sensoren 8 und 9 durchgeführt werden, in dem die Schalter 6 und 7 kurzzeitig geschlossen bzw. die Sensoren 8 und 9 kurzzeitig in einen Zustand versetzt werden, in dem sie bei ordnungsgemäßer Funktion der Stromkreise die zugeordnete Last einschalten. Auf der Anzeige 42 erscheint bei ordnungsgemäßer Funktion der Schalter bzw. die Sensoren beispielsweise ein Code oder die Benennung des des Schalters bzw. Sensors und ermöglicht eine Aussage über die Funktionsfähigkeit des geprüften Elements. Sollte trotz der erkannten Funktionsfähigkeit des Schalters bzw. Sensors und des zugeordneten, mit Hilfe des Drehschalters 21 geprüften Teils des Stromkreises noch ein Fehler vorhanden sein, so kann dieser eindeutig lediglich zwischen der Anschlußstelle der Verbindungsleitungen zum Codierer 41 und den zugeordneten Öffnerkontakten 37 bis 40 liegen.

Mit der dargestellten Prüfeinrichtung ist es damit ohne weiteres möglich, einen aufgetretenen Fehler schnell und eindeutig zu lokalisieren. Der apparative Aufwand sowie die Herstellungskosten für die Prüfeinrichtung sind verschwindend gering. Letzteres gilt insbesondere dann, wenn die Steuereinheit 1 als Mikroprozessor ausgebildet ist, die dargestellten Schaltungsmaßnahmen lassen sich dann mit geringem Aufwand softwaremäßig realisieren.

## Patentansprüche

1. Prüfeinrichtung für Stromkreise eines Kraftfahrzeugs, bei denen Eingangssignale in einer gemeinsamen zentralen Steuereinheit (1) in Ausgangssignale zum Schalten verschiedener Verbraucher (16 bis 19) umgesetzt und die Verbraucher während eines Prüfzyklus unabhängig von den Eingangssignalen geschaltet werden, gekennzeichnet durch einen Generator (20), der für Verbraucher, die durch Lastschalter (10' bis 13') geschaltet sind, den Ausgangssignalen der Steuereinheit (1) zumindest ähnliche Signale erzeugt und diese zyklisch zu den Verbrauchern liefert.

2. Prüfeinrichtung nach Anspruch 1, dadurch gekennzeichnet, daß der Generator (20) in der Steuereinheit (1) integriert ist.

3. Prüfeinrichtung nach Anspruch 1 oder 2, dadurch gekennzeichnet, daß der Generator (20) mittels eines kurzen Prüfbefehls aktivierbar ist.

4. Prüfeinrichtung nach einem der Ansprüche 1 bis 3, dadurch gekennzeichnet, daß die Eingangssignale der Steuereinheit (1) auf einer Anzeige (42) darstellbar sind.

## Claims

1. A device for testing electric circuits on a motor vehicle, where input signals are converted in a common central control unit (1) into output signals for switching various loads (16 to 19) and the loads during a test cycle are switched independently of the input signals, characterised by a generator (20) which, in the case of loads switched by load isolators (10' to 13'), generates signals which are at least similar to the output signals from the control unit (1) and delivers them in cyclic manner to the loads.

2. A test device according to claim 1, characterised in that the generator (20) is incorporated in the control unit (1).

3. A test device according to claim 1 or 2, characterised in that the generator (20) is adapted to be activated by a short test command.

4. A test device according to any of claims 1 to 3, characterised in that the input signals from the control unit (1) are adapted for display on a display unit (42).

**Revendications**

1. Dispositif d'essai pour circuits électriques d'un véhicule automobile, selon lequel les signaux d'entrée d'une unité de commande (1) centrale, commune, sont transformés en des signaux de sortie pour commuter différents utilisateurs (16-19) et pendant un cycle d'essai, les utilisateurs sont commutés indépendamment des signaux d'entrée, installation caractérisée par un générateur (20) qui génère des signaux au moins analogues à des signaux de sortie de l'unité de commande (1) pour les utilisateurs qui sont commutés par des commutateurs de puissance (10'-13') et le générateur fournit ces signaux de manière cyclique aux utilisateurs.

2. Installation d'essai, selon la revendication 1, caractérisée en ce que le générateur (20) est intégré à l'unité de commande (1).

3. Installation d'essai selon la revendication 1 ou 2, caractérisée en ce que le générateur (20) est susceptible d'être activé par un ordre d'essai, court.

4. Installation d'essai selon l'une quelconque des revendications 1 à 3, caractérisée en ce que les signaux d'entrée de l'unité de commande (1) sont affichables sur un moyen d'affichage (42).

1